# EUROPEAN PATENT APPLICATION

(11) **EP 4 779 680 A1**
(43) Date of publication of application: **22.07.2026**
(21) Application number: 24865462.6
(22) Date of filing: 11.09.2024
(51) Int. Cl.: H01L 21/60, H05K 13/04

(54) **MOUNTING DEVICE AND MOUNTING METHOD**

(30) Priority: 11.09.2023 JP 2023147061
(71) Applicant: Yamaha Robotics Co., Ltd., Musashimurayama-shi, Tokyo 208-8585 (JP)
(72) Inventor: SAITO, Takashi, Musahimurayama-shi, Tokyo 2088585 (JP); NOMURA, Yudai, Musahimurayama-shi, Tokyo 2088585 (JP)
(74) Representative: Becker, Eberhard
(86) International application number: PCT/JP2024/032474
(87) International publication number: WO 2025/057962

(57) **Abstract**

Provided is a technology related to a compact mounting device capable of separating a substrate from a heat source when the substrate is not desired to be heated. A mounting device (1) for mounting electronic components (CH11, CH12, ...) on substrates (SB1, SB2, ...) comprises: a lower die (10) configured to hold the substrates (SB1, SB2, ...) on which the electronic components (CH11, 12, ...) are placed; and an upper die (20) disposed opposite the lower die (10). The lower die (10) is provided with: a cavity plate (11A) that faces the space between the lower die (10) and the upper die (20); a heater (14) that heats the cavity plate (11A); lifter pins (12A, 12B, ...) that hold the substrates (SB1, SB2, ...); and set pins (16) that are pressed by the upper die (20). The lifter pins (12A, 12B, ...) are configured to be able to change the distance (d) between the substrates (SB1, SB2, ...) and the cavity plate (11A) by means of pressing force applied from the upper die (20) to the set pins (16).

## Description

### Technical Field

The present invention relates to a mounting device and a mounting method using the device.

### Background Art

There are bonding technologies for heating a bonding material or bump disposed between a substrate and an electronic component while applying pressure. For example, sintering bonding is to sinter a bonding material disposed between a substrate and an electronic component by heating the bonding material while applying pressure. Bump bonding is to melt a bump disposed between a substrate and an electronic component by heating the bump while applying pressure. In such bonding technologies, heating the bonding material or bump without applying pressure causes a reduction in adhesive strength between the substrate and the electronic component.

To prevent the bonding material or bump from being heated at an undesired timing, a device has been proposed that provides a floating mechanism for lifting the substrate within the mold and separates the substrate from a heat source until the desired timing. For example, Patent Document 1 discloses a bonding apparatus that includes movable support pins capable of protruding from a heated clamp surface and can lift a workpiece in which metal bumps such as solder bumps are temporarily bonded on a substrate with an adhesive layer using the movable support pins, thereby separating the workpiece from the clamp surface until the timing of main bonding.

### Related Art Document

### Patent Document

Patent Document 1: Japanese Patent Application Laid-Open No. 2012-231080

### SUMMARY OF THE INVENTION

### Problem to be Solved by the Invention

The bonding apparatus disclosed in Patent Document 1 moves the movable support pins up and down by a lifting mechanism (not shown). Adding a servo motor or the like as the lifting mechanism increases the number of parts and the size of the apparatus. The present invention has been made in view of such a problem, and aims to provide a technology related to a compact mounting device that is capable of separating a substrate from a heat source when the substrate is not desired to be heated.

### Means for Solving the Problem

A mounting device according to one aspect of the present invention is a mounting device for mounting at least one electronic component on at least one substrate, and includes: a first mold configured to hold the at least one substrate on which the at least one electronic component is placed; and a second mold disposed opposite to the first mold. The first mold includes: a heating plate facing a space between the first mold and the second mold; a heater heating the heating plate; at least one holding member holding the at least one substrate; and at least one pressing member pressed by the second mold. The at least one holding member is configured to be capable of changing a distance between the at least one substrate and the heating plate by a pressing force applied from the second mold to the at least one pressing member.

A mounting method according to another aspect of the present invention is a mounting method for mounting at least one electronic component on at least one substrate, and includes: preparing a first mold configured to hold the at least one substrate on which the at least one electronic component is placed; and preparing a second mold disposed opposite to the first mold. The first mold includes: a heating plate facing a space between the first mold and the second mold; a heater heating the heating plate; at least one holding member holding the at least one substrate; and at least one pressing member pressed by the second mold. The mounting method further includes changing, by the at least one holding member, a distance between the at least one substrate on which the at least one electronic component is placed or mounted and the heating plate by a pressing force applied from the second mold to the at least one pressing member.

### Effects of the Invention

According to the present invention, it is possible to provide a technology related to a compact mounting device that is capable of separating a substrate from a heat source when the substrate is not desired to be heated.

### BRIEF DESCRIPTION OF THE DRAWINGS

[FIG. 1] is a cross-sectional view showing an example of the mounting device according to one embodiment of the present invention.
[FIG. 2] is a cross-sectional view showing an example of the gas supply port shown in FIG. 1.
[FIG. 3] is a flow diagram showing an example of the mounting method using the mounting device according to one embodiment of the present invention.
[FIG. 4] is a flow diagram showing an example of the mounting method using the mounting device according to one embodiment of the present invention, continuing from FIG. 3.
[FIG. 5] is a diagram showing a temperature profile of the mounting method shown in FIG. 3 and FIG. 4.
[FIG. 6] is a cross-sectional view showing a state in which the mold is closed to the second position, the degassing chamber is closed, and inert gas is supplied while degassing.
[FIG. 7] is a cross-sectional view showing a state in which the mold is closed to the third position and the distance between the substrate and the heating plate is reduced.
[FIG. 8] is a cross-sectional view showing a state in which the mold is closed to the fourth position and heating is performed by the heating plate while pressure is applied by the movable piece.
[FIG. 9] is a cross-sectional view showing a state in which the mold is opened to the second position and the distance between the substrate and the heating plate is increased.

### DESCRIPTION OF THE EMBODIMENTS

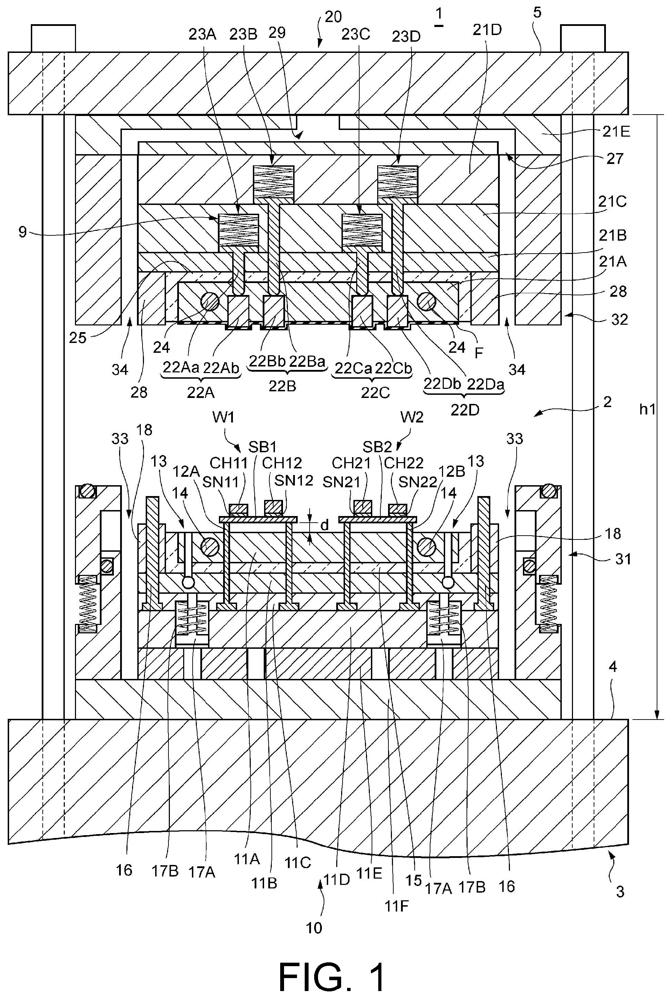

Preferred embodiments of the present invention will be described with reference to the accompanying drawings. In each drawing, components with the same reference numerals have the same or similar configurations. In the following description, "upper" and "lower" are defined based on gravity. FIG. 1 is a cross-sectional view showing an example of a mounting device 1 according to one embodiment of the present invention. The mounting device 1 is a mounting device for mounting at least one electronic component on each of at least one substrate.

In the illustrated example, the mounting device 1 is configured as a sintering device that sinters bonding materials SN11 and SN12 disposed between a substrate SB1 and electronic components CH11 and CH12 by heating and pressurizing the bonding materials SN11 and SN12 to bond the substrate SB1 and the electronic components CH11 and CH12. The number of electronic components and the number of bonding materials on one substrate are not necessarily two as illustrated, and three or more electronic components may be arranged in a matrix on one substrate, or one electronic component may be disposed on one substrate. Further, although in the illustrated example, two substrates are set left and right as viewed by the operator, multiple substrates may be set front and back as viewed by the operator. The mounting device 1 is not limited to a sintering device, and may be a flip chip bonder that heats solder bumps or the like disposed between the electronic component SB1 and the substrates CH11 and CH12 while applying pressure, or may be other mounting devices.

In the following description, the substrate SB1, the electronic components CH11 and CH12, and the bonding materials SN11 and SN12 are collectively called workpiece W1. The mounting device 1 may perform mounting processing on multiple workpieces with one heating and pressurizing operation. In the illustrated example, the mounting processing is performed on two workpieces W1 and W2 with one heating and pressurizing operation. The other workpiece W2 includes a substrate SB2, electronic components CH21 and CH22, and bonding materials SN21 and SN22, similar to the workpiece W1. The number of electronic components for each substrate is at least one, and is not necessarily two. The number of electronic components may be one, or may be three or more.

In the space between a lower mold 10 and an upper mold 20, the workpiece W1 is supplied with the substrate SB1 facing the lower mold 10 and the electronic components CH11 and CH12 facing the upper mold 20, and the workpiece W2 is supplied with the substrate SB2 facing the lower mold 10 and the electronic components CH21 and CH22 facing the upper mold 20. In the following description, the surfaces on which the electronic components CH11, CH12, CH21, and CH22 are mounted may be called the front surfaces or upper surfaces of the substrates SB1 and SB2, and the surfaces on the opposite side may be called the back surfaces or lower surfaces of the substrates SB1 and SB2.

In the case where the mounting device 1 is a sintering device, preferred examples of the substrates SB1 and SB2 are Direct Bonded Copper (DBC) substrates of high heat dissipation ceramic insulation with copper circuit, Direct Bonded Aluminum (DBA) substrates of high heat dissipation ceramic insulation with aluminum circuit, and the like. The substrates 102 are not limited to ceramic substrates, and may be semiconductor substrates such as silicon substrates, metal substrates such as lead frames, or insulator substrates such as PCB (Printed Circuit Board) substrates. The thicknesses of the substrates SB1 and SB2 may be different from each other or may be the same, for example.

The electronic components CH11, CH12, CH21, and CH22 are, for example, semiconductor chips. The electronic components CH11, CH12, CH21, and CH22 are not limited to semiconductor chips, and may be passive elements such as resistors, inductors, capacitors, and crystal oscillators or may be active elements such as diodes, transistors, thyristors, and operational amplifiers. The heights of the electronic components CH11 and CH12 may be different from each other or may be the same. The heights of the electronic components CH21 and CH22 may also be different from each other or may be the same.

The bonding materials SN11, SN12, SN21, and SN22 are, for example, sintering materials including silver (Ag) nanoparticles. The mounting device 1 heats and pressurizes the bonding materials SN11, SN12, SN21, and SN22 to sinter the bonding materials SN11, SN12, SN21, and SN22. The bonding materials SN11, SN12, SN21, and SN22 are not limited to sintering materials, and may be semi-sintering materials, metal solder, organic adhesives, or inorganic adhesives. The form of the bonding material is, for example, an aggregate of powder. The form of the bonding material may be liquid, semi-solid, or may be solid or film-like.

As shown in FIG. 1, the mounting device 1 includes a press device 3 and a mold 2 attached to the press device 3. In the illustrated example, the mounting device 1 further includes degassing chambers 31 and 32. The press device 3 includes a pair of lower platen 4 and upper platen 5 that are connected by tie bars.

The mold 2 includes an upper mold base 21E fixed to the upper platen 5 and a lower mold base 11F fixed to the lower platen 4. Between the upper mold base 21E and the lower mold base 11F, the main plates constituting the mold 2 (support plates 21D and 21C, upper mold chase 21B, lower mold chase 11B, ejector pin plate 11C, retainer plate 11D, etc.) are fixed.

In the following description, various plates fixed to the lower mold base 11F and components thereof are collectively called the lower mold 10, and various plates fixed to the upper mold base 21E and components thereof are collectively called the upper mold 20. The lower mold 10 is an example of the "first mold" configured to hold the workpieces W1 and W2, and the upper mold 20 is an example of the "second mold" disposed opposite to the first mold.

The lower mold 10 mainly includes a lower mold base 11F, a support pillar 11E, a retainer plate 11D, an ejector pin plate 11C, a lower mold chase 11B, etc. The lower mold chase 11B is fixed above the lower mold base 11F via multiple support pillars 11E that protrude in a columnar shape from the lower mold base 11F.

The ejector pin plate 11C and the retainer plate 11D are disposed below the lower mold chase 11B. The ejector pin plate 11C and the retainer plate 11D have holes through which the support pillars 11E penetrate. The ejector pin plate 11C and the retainer plate 11D are fixed to each other and are configured to be slidable vertically between the lower mold chase 11B and the lower mold base 11F.

Various components including a cavity plate 11A are fixed to the lower mold chase 11B. In the illustrated example, the cavity plate 11A, a side block 18 that fixes the cavity plate 11A, a thermal insulation member 15 disposed to surround the lower surface and side surfaces of the cavity plate 11A, a spring 17B, and a spring sleeve 17A are fixed to the lower mold chase 11B.

Both the ejector pin plate 11C and the retainer plate 11D face the cavity plate 11A from the lower side opposite to the upper mold 20. Multiple lifter pins 12A and 12B that can protrude from and retract into the cavity plate 11A, and a set pin 16 that comes into contact with the upper mold 20 in the case of mold closing, are fixed to the ejector pin plate 11C and the retainer plate 11D.

In response to both the ejector pin plate 11C and the retainer plate 11D approaching the cavity plate 11A, the lifter pins 12A and 12B protrude from the cavity plate 11A, and in response to both the ejector pin plate 11C and the retainer plate 11D moving away from the cavity plate 11A, the lifter pins 12A and 12B retract into the cavity plate 11A. In the following description, the ejector pin plate 11C and the retainer plate 11D may be collectively called the movable plates 11C and 11D.

The cavity plate 11A is formed in a block shape using a material such as alloy tool steel. The cavity plate 11A is provided at a position closest to the upper mold 20 and is adjacent to the space between the lower mold 10 and the upper mold 20 during mold opening. A heater 14 is provided inside the cavity plate 11A. The heater 14 heats the substrates SB1 and SB2 via the cavity plate 11A in the case of the lower mold 10 and the upper mold 20 being closed. Thereby, the bonding materials SN11, SN12, SN21, and SN22 are heated. The cavity plate 11A is an example of the "heating plate" that faces the space between the lower mold 10 and the upper mold 20 and is heated by the heater 14.

The thermal insulation member 15 is provided between the cavity plate 11A and the lower mold chase 11B, and between the cavity plate 11A and the side block 18. The thermal insulation member 15 is formed of a material with a large thermal resistance value such as glass wool or rock wool, and suppresses direct heat conduction from the cavity plate 11A to the lower mold chase 11B and suppresses heat conduction from the cavity plate 11A to the lower mold chase 11B via the side block 18.

In other words, the thermal insulation member 15 is disposed to separate the gas piping provided in the lower mold chase 11B from the heater 14, and suppresses an increase in temperature of the nitrogen gas supplied from a gas supply port 13. Further, the thermal insulation member 15 is disposed to separate the spring 17B from the heater 14, and suppresses a decrease in elastic force of the spring 17B. That is, the thermal insulation member 15 limits the heating target to the cavity plate 11A, thereby accelerating the temperature rise of the heater 14 and making other members less susceptible to the influence of heat.

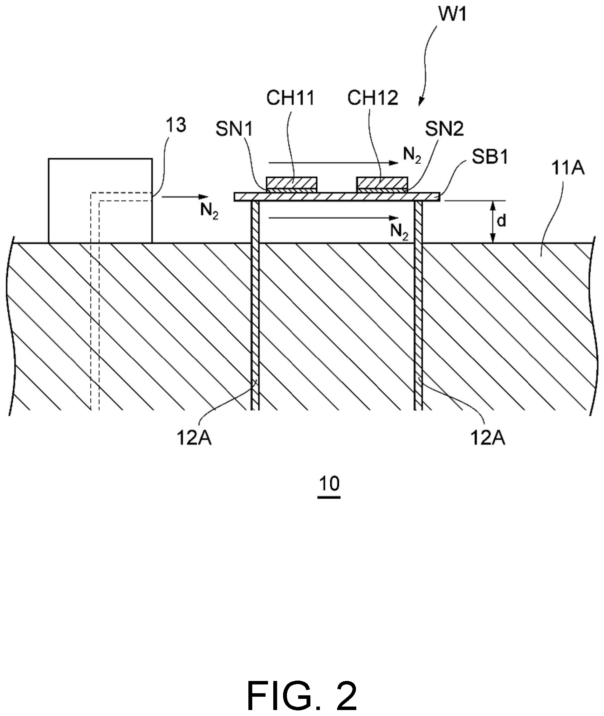

The side block 18 is provided outside the cavity plate 11A in plan view from the upper mold 20. The side block 18 comes into contact with the upper mold 20 in the case of the lower mold 10 and the upper mold 20 being closed. In the illustrated example, the gas supply port 13 for supplying gas such as nitrogen (N₂) gas to the cavity plate 11A is provided in a region outside the heater 14. The gas supply port 13 will be described in detail later with reference to FIG. 2.

The spring 17B is an example of the "biasing member" and biases the ejector pin plate 11C and the retainer plate 11D, as an example of the above-mentioned "movable plate", upward toward the lower mold chase 11B. The base portion, that is, the upper end portion of the spring sleeve 17A is a stepped bolt and is fixed to the lower surface of the lower mold chase 11B. The base portion of the spring sleeve 17A may be a combination of a washer, a sleeve, and a bolt. A flange is provided at the tip portion, that is, the lower end portion of the spring sleeve 17A.

The retainer plate 11D has a through hole formed therein that is larger than the tip portion of the spring sleeve 17A. The ejector pin plate 11C has a counterbore with the same diameter as the through hole and a through hole formed at the center of the counterbore through which the base portion of the spring sleeve 17A is inserted. The spring sleeve 17A is inserted through the through hole of the retainer plate 11D and the through hole of the ejector pin plate 11C.

The spring 17B is provided in a helical manner around the spring sleeve 17A between the flange of the spring sleeve 17A and the counterbore of the ejector pin plate 11C. That is, the spring sleeve 17A is inserted into the helical spring 17B. The spring 17B applies an elastic force in a direction that separates the ejector pin plate 11C and the flange of the tip portion of the spring sleeve 17A from each other.

In other words, the spring 17B constantly biases the ejector pin plate 11C and the retainer plate 11D toward the lower mold chase 11B via the spring sleeve 17A, that is, presses the ejector pin plate 11C and the retainer plate 11D in a direction to move upward. The spring 17B is not limited to a coil spring, and may be a leaf spring or the like.

The lifter pins 12A and 12B are inserted into the through holes that penetrate the cavity plate 11A, the lower mold chase 11B, the ejector pin plate 11C, and the thermal insulation member 15. The lifter pins 12A and 12B have the same length, and three to four or more lifter pins are used to hold one workpiece W1 in order to keep the workpiece W1 parallel. The upper mold 20 side is the tip portion, and the lower mold base 11F side is the base portion. The base portions of the lifter pin 12B and the set pin 16 are sandwiched between the ejector pin plate 11C and the retainer plate 11D and are screwed. The lifter pin 12B and the set pin 16 move up and down in conjunction with the ejector pin plate 11C and the retainer plate 11D.

The lifter pin 12A supports the substrate SB1 by bringing the tip portion thereof into contact with the back surface of the substrate SB1, and the lifter pin 12B supports the substrate SB2 by bringing the tip portion thereof into contact with the back surface of the substrate SB2. The lifter pins 12A and 12B are configured to be movable up and down, and bring the substrates SB1 and SB2 into contact with and separate the substrates SB1 and SB2 from the cavity plate 11A.

Specifically, the lifter pins 12A and 12B are configured to be able to advance from the cavity plate 11A toward the upper mold 20 and retract. In the case of the lifter pins 12A and 12B advancing into the space between the lower mold 10 and the upper mold 20, that is, during mold opening, the workpieces W1 and W2 supported by the lifter pins 12A and 12B are separated from the cavity plate 11A. In the case of the lifter pins 12A and 12B retracting from the space between the lower mold 10 and the upper mold 20, that is, during mold closing, the workpieces W1 and W2 are supported in contact with the cavity plate 11A.

In response to the ejector pin plate 11C and the retainer plate 11D approaching the cavity plate 11A (moving upward), the tip portions of the lifter pins 12A and 12B protrude from the cavity plate 11A. That is, the tips of the lifter pins 12A and 12B advance into the space between the lower mold 10 and the upper mold 20.

In response to the ejector pin plate 11C and the retainer plate 11D moving away from the cavity plate 11A (moving downward), the tip portions of the lifter pins 12A and 12B are housed inside the cavity plate 11A, and the surfaces of the surface end portions of the lifter pins 12A and 12B become flush with the surface of the cavity plate 11A. That is, the lifter pins 12A and 12B retract from the space between the lower mold 10 and the upper mold 20.

Each of the lifter pins 12A and 12B is formed in a rod shape. The lifter pins 12A and 12B are an example of the "holding member" that holds the substrates SB1 and SB2. The holding member is not limited to lifter pins. The holding member may be an elongated plate-shaped member that holds the end portion of the workpiece.

The substrates SB1 and SB2 are supported by the tip portions (upper end portions) of the lifter pins 12A and 12B. Each of the lifter pins 12A and 12B is fixed to the ejector pin plate 11C and the retainer plate 11D, which are movable plates, in a state of being inserted into the through hole that penetrates the cavity plate 11A.

The set pin 16 is inserted through a through hole that penetrates the side block 18, the lower mold chase 11B, and the ejector pin plate 11C. The set pin 16 uses the upper mold 20 side as the tip portion and the lower mold base 11F side as the base portion. The base portion of the set pin 16 is sandwiched between the ejector pin plate 11C and the retainer plate 11D. The tip portion of the set pin 16 faces the side block 28 of the upper mold 20.

In the case of the lower mold 10 and the upper mold 20 being closed, the set pin 16 is pressed by the side block 28 and presses down the ejector pin plate 11C and the retainer plate 11D. By pressing down the ejector pin plate 11C and the retainer plate 11D, the lifter pin 12B is pressed down in conjunction, causing the substrates SB1 and SB2 on the lifter pin 12B to move downward. Further, in order to press down the ejector pin plate 11C and the retainer plate 11D in parallel, it is preferable to dispose the set pins 16 at the four corners of the substrate SB1.

One of the features of the mounting device 1 according to the present embodiment is that the mounting device 1 includes a floating mechanism that lifts the substrates SB1 and SB2 so that the substrates SB1 and SB2 are separated from the cavity plate 11A. In the illustrated example, the floating mechanism includes the lifter pins 12A and 12B that are inserted through the through holes of the cavity plate 11A to be able to come into contact with the back surfaces of the substrates SB1 and SB2, the movable ejector pin plate 11C and the movable retainer plate 11D to which the base portions (lower end portions) of the lifter pins 12A and 12B are fixed, the coil spring 17B that biases the movable ejector pin plate 11C and the movable retainer plate 11D toward the cavity plate 11A, the set pin 16 that presses down the movable ejector pin plate 11C and the movable retainer plate 11D against the biasing force of the coil spring 17B in response to being pressed from the upper mold 20, etc.

The upper mold 20 mainly includes an upper mold base 21E, an upper support plate 21D, a lower support plate 21C, an upper mold chase 21B, a pressure adjustment mechanism 9, etc. The upper support plate 21D and the lower support plate 21C are fixed to the upper mold base 21E. The upper mold chase 21B is fixed to the upper mold base 21E via the upper support plate 21D and the lower support plate 21C.

Various components including a cavity plate 21A are fixed to the upper mold chase 21B. In the illustrated example, the upper mold chase 21B is provided with the cavity plate 21A, the side block 28 that fixes the cavity plate 21A, the thermal insulation member 25 that is disposed to surround the upper surface and side surfaces of the cavity plate 21A, and a part of the pressure adjustment mechanism 9. The pressure adjustment mechanism 9 will be described in detail later.

The cavity plate 21A is provided at a position closest to the lower mold 10. A heater 24 is provided inside the cavity plate 21A. The heater 24 heats movable pieces 22Ab, 22Bb, 22Cb, and 22Db, which will be described later, via the cavity plate 21A.

In the case of the lower mold 10 and the upper mold 20 being closed, the heater 24 heats the electronic components CH11, CH12, CH21, and CH22 via the movable pieces 22Ab, 22Bb, 22Cb, and 22Db and a film F. Thereby, the bonding materials SN11, SN12, SN21, and SN22 are heated.

The side block 28 is provided on the side of the upper mold chase 21B that faces the lower mold 10. In plan view from the upper mold 20, the side block 28 is provided outside the cavity plate 21A. The side block 28 is a portion of the upper mold 20 that comes into contact with the lower mold 10 in the case of the lower mold 10 and the upper mold 20 being closed. The side block 28 fixed to the upper mold chase 21B faces the side block 18 fixed to the lower mold chase 11B in the vertical direction.

The above-mentioned set pin 16 is an example of the "pressing member" that is pressed by the upper mold 20, which is the second mold. In the case of the lower mold 10 and the upper mold 20 being closed, the side block 28 of the upper mold 20 comes into contact with and presses the set pin 16. In the case of the lower mold 10 and the upper mold 20 being closed, the side block 28 may be separated from the set pin 16.

The thermal insulation member 25 is provided between the cavity plate 21A and the upper mold chase 21B, and is provided between the cavity plate 21A and the side block 28. The thermal insulation member 25 suppresses direct heat conduction from the cavity plate 21A to the upper mold chase 21B, and suppresses heat conduction from the cavity plate 21A to the upper mold chase 21B via the side block 28.

The thermal insulation member 25 suppresses thermal deterioration of springs 23A, 23B, 23C, and 23D by partitioning the heater 24 and an internal space 23. That is, the thermal insulation member 25 limits the heating target to the cavity plate 21A, thereby accelerating the temperature rise of the heater 24 and making other members less susceptible to the influence of heat.

In the case of performing the mounting processing, the film F is stretched on the surface of the cavity plate 21A that faces the lower mold 10. Suction holes (not shown) for suctioning the film F are formed on the lower surface of the cavity plate, and the film F is adsorbed. The suction holes are connected to an external vacuum suction pump.

As examples of the film F, film materials that are excellent in heat resistance, easy peelability, flexibility, and extensibility are suitably used, such as PTFE (polytetrafluoroethylene), ETFE (ethylene-tetrafluoroethylene copolymer), PET (polyethylene terephthalate), FEP (tetrafluoroethylene-hexafluoropropylene copolymer), fluorine-impregnated glass cloth, PP (polypropylene), and PVDC (polyvinylidene chloride).

The film F inhibits intrusion of powder and gas generated from the bonding materials SN11, SN12, SN21, and SN22 into gaps of the upper mold 20, and suppresses malfunction of the upper mold 20. Additionally, the film F functions as a cushioning material between the movable pieces 22Ab, 22Bb, 22Cb, and 22Db and the electronic components CH11, CH12, CH21, and CH22, and has an effect of suppressing damage to the electronic components CH11, CH12, CH21, and CH22 during pressurization.

The upper mold 20 includes the pressure adjustment mechanism 9 that adjusts the pressure applied to each of the electronic components CH11, CH12, CH21, and CH22, thereby preventing mounting defects due to insufficient pressure or excessive pressure on the bonding materials SN11, SN12, SN21, and SN22 caused by dimensional differences of the substrates SB1 and SB2 and the electronic components CH11, CH12, CH21, and CH22.

In the illustrated example, the pressure adjustment mechanism 9 is configured with movable mechanisms 22A, 22B, 22C, and 22D, springs 23A, 23B, 23C, and 23D, etc. The movable mechanisms 22A, 22B, 22C, and 22D are connected to the springs 23A, 23B, 23C, and 23D and configured to be movable up and down.

The pressure adjustment mechanism 9 absorbs differences in thickness of the substrates SB1 and SB2, differences in height of the electronic components CH11, CH12, CH21, and CH22, and differences in thickness of the bonding materials SN11, SN12, SN21, and SN22, and pressurizes the bonding materials SN11, SN12, SN21, and SN22 with substantially uniform pressure. Springs 23A, 23B, 23C, and 23D with different spring constants may be selected to make the pressure applied to each of the electronic components CH11, CH12, CH21, and CH22 different from each other.

The configuration of the pressure adjustment mechanism 9 is not limited to the illustrated example. The pressure adjustment mechanism 9 may have, for example, a configuration that includes a viscous member such as silicone oil sealed in a closed space within the upper mold 20, a plunger that pressurizes the viscous member to adjust the internal pressure, and multiple pistons that are moved up and down by the internal pressure of the viscous member, with the movable mechanisms 22A, 22B, 22C, and 22D respectively connected to the multiple pistons.

In this configuration, pressure equal to the internal pressure of the viscous member is applied to all the pistons, so it is possible to absorb the differences in thickness of the substrates SB1 and SB2, differences in height of the electronic components CH11, CH12, CH21, and CH22, and differences in thickness of the bonding materials SN11, SN12, SN21, and SN22, and pressurize the bonding materials SN11, SN12, SN21, and SN22 with uniform pressure.

Regarding the rod-shaped members such as the movable mechanisms 22A, 22B, 22C, and 22D in the upper mold 20, the base block 21E side is used as the base portion, and the lower mold 10 side is used as the tip portion. The base portion of the movable mechanism 22A receives the elastic force of the spring 23A, and the tip portion of the movable mechanism 22A pressurizes the electronic component CH11 based on the elastic force of the spring 23A. As a result, the bonding material SN11 is pressurized by the movable mechanism 22A via the electronic component CH11.

Similarly, the movable mechanism 22B pressurizes the electronic component CH12 based on the elastic force of the spring 23B, and the bonding material SN12 is pressurized by the movable mechanism 22B via the electronic component CH12. The movable mechanism 22C pressurizes the electronic component CH21 based on the elastic force of the spring 23C, and the bonding material SN21 is pressurized by the movable mechanism 22C via the electronic component CH21. The movable mechanism 22D pressurizes the electronic component CH22 by the elastic force of the spring 23D, and the bonding material SN22 is pressurized by the movable mechanism 22D via the electronic component CH22.

The movable mechanism 22A includes a rod 22Aa and the movable piece 22Ab. Similarly, the movable mechanisms 22B, 22C, and 22D respectively include the rods 22Ba, 22Ca, and 22Da and the movable pieces 22Bb, 22Cb, and 22Db. The movable pieces 22Ab, 22Bb, 22Cb, and 22Db respectively press the corresponding electronic components CH11, CH12, CH21, and CH22.

In the illustrated example, the movable pieces 22Ab, 22Bb, 22Cb, and 22Db correspond one-to-one with the same number as the electronic components CH11, CH12, CH21, and CH22. The movable pieces 22Ab, 22Bb, 22Cb, and 22Db may be fewer than the electronic components CH11, CH12, CH21, and CH22. In that case, one movable piece (for example, movable piece 22Ab) may press multiple electronic components (for example, electronic components CH11 and CH12).

The springs 23A, 23B, 23C, and 23D are compressed in the vertical direction to generate an elastic force in the direction of pressing down the movable mechanisms 22A, 22B, 22C, and 22D. The springs 23A, 23B, 23C, and 23D are, for example, coil springs formed using a metal material. The springs 23A, 23B, 23C, and 23D are not limited to coil springs, and may be leaf springs or the like.

In the case of performing the mounting processing, the sides of the rods 22Ab, 22Bb, 22Cb, and 22Db that are in contact with the electronic components CH11, CH12, CH21, and CH22 are covered by the continuous film F. The film F prevents dust generated from the bonding materials SN11, SN12, SN21, and SN22 from adhering to and contaminating the upper mold 20.

The heater 24 heats the rods 22Ab, 22Bb, 22Cb, and 22Db via the cavity plate 21A. In the case of the lower mold 10 and the upper mold 20 being combined, the heater 24 heats the electronic components CH11, CH12, CH21, and CH22 via the rods 22Ab, 22Bb, 22Cb, and 22Db. Thereby, the bonding materials SN11, SN12, SN21, and SN22 are heated. The heater 24 is provided inside the block portion 21A. The heater 24 is, for example, a sheathed heater.

The degassing chambers 31 and 32 are openable and closable annular vacuum chambers that surround the lower mold 10 and the upper mold 20, and include the lower chamber 31 and the upper chamber 32. The lower chamber 31 is erected on the lower mold base 11F of the lower mold 10. In plan view from the upper mold 20, the lower chamber 31 is provided outside the side block 18. A degassing path 33 through which degassing gas passes is provided between the lower chamber 31 and the lower mold chase 11B, the ejector pin plate 11C, the retainer plate 11D, the support pillar 11E, and the side block 18.

The upper chamber 32 is erected downward on the upper mold base 21E of the upper mold 20. In plan view from the lower mold 10, the upper chamber 32 is provided outside the side block 28. A degassing path 34 through which degassing gas passes is provided between the upper chamber 32 and the upper mold chase 21B, the lower support plate 21C, the upper support plate 21D, and the side block 28.

The degassing path 34 is connected to a degassing path 27 provided in the upper mold base 21E. The degassing path 27 is connected to a degassing port 29 provided in the upper mold base 21E. The degassing port 29 is connected to a vacuum pump outside the mold. Through the degassing port 29, the atmosphere of the lower mold 10 and the upper mold 20 within the degassing chamber composed of the lower chamber 31 and the upper chamber 32 is degassed.

FIG. 2 is a cross-sectional view showing an example of the gas supply port 13 shown in FIG. 1. As shown in FIG. 2, the gas supply port 13 faces the end surfaces of the substrates SB1 and SB2, and supplies gas to flow along the front surfaces and back surfaces of the substrates SB1 and SB2. In the illustrated example, the lower mold 10 has multiple gas supply ports 13. The upper mold 20 may have the gas supply port 13, or both the lower mold 10 and the upper mold 20 may have the gas supply ports 13.

The gas supply port 13 supplies gas such as nitrogen (N₂) gas toward the substrates SB1 and SB2 and the electronic components CH11, CH12, CH21, and CH22. The gas supply port 13 is provided on the surface of the cavity plate 11A that faces the upper mold 20, and opens toward the upper mold 20. Therefore, the gas supply port 13 rapidly removes oxidizing gas from around the workpieces W1 and W2 during heating, and places the workpieces W1 and W2 under a nitrogen atmosphere.

Additionally, the gas supply port 13 performs gas cooling for the workpieces W1 and W2 by directing nitrogen gas toward the workpieces W1 and W2 during cooling. In plan view from the upper mold 20, multiple gas supply ports 13 are provided outside the workpieces W1 and W2. Gas piping that allows passage of the nitrogen gas supplied by the gas supply port 13 is provided in the lower mold chase 11B. The gas supply port 13 supplies inert gas to the space between the lower mold 10 and the upper mold 20.

The above-described gas supply port 13 may be used as the gas supply port that supplies inert gas into the depressurized degassing chambers 31 and 32. A gas supply port that supplies inert gas into the depressurized degassing chambers 31 and 32 and the gas supply port 13 dedicated to cooling the substrates SB1 and SB2, etc. may be prepared separately.

The inert gas supplied by the gas supply port 13 is not limited to nitrogen gas, and may be carbon gas, fluorocarbon, noble gas, or the like. The gas supply port 13 may directly or indirectly blow inert gas toward the substrates SB1 and SB2, the electronic components CH11, CH12, CH21, and CH22, the bonding materials SN11, SN12, SN21, and SN22, etc. The gas supply port 13 may be provided in the cavity plate 11A of the lower mold 10, or may be provided in both the cavity plates 11A and 21A of the lower mold 10 and the upper mold 20. The gas supply port 13 may be provided in the side block 18, 28 of at least one of the lower mold 10 and the upper mold 20, or may be provided in the above-mentioned degassing chambers 31 and 32.

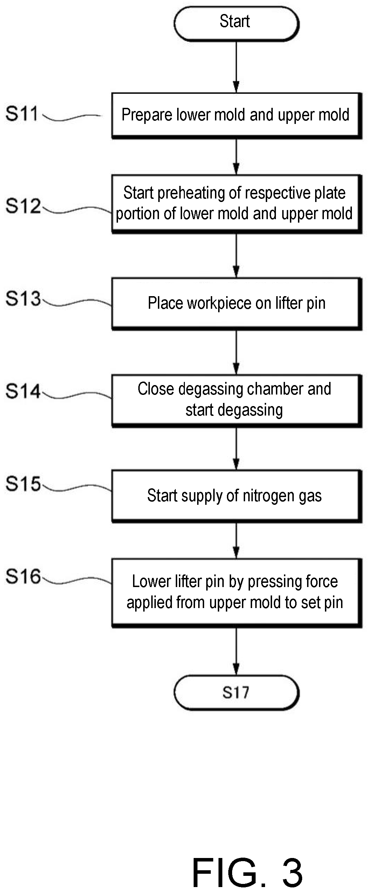

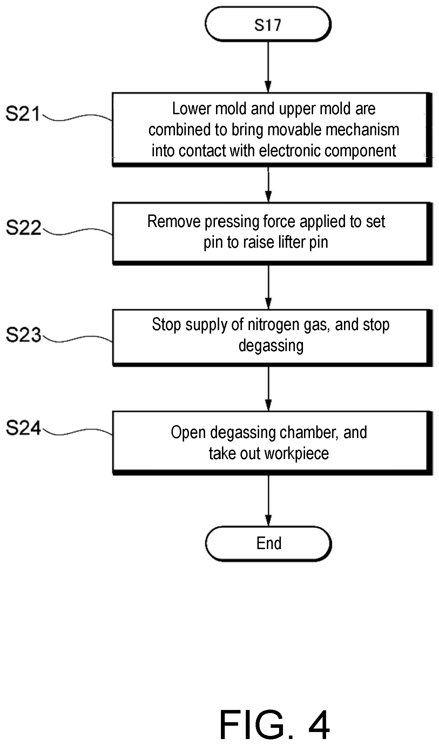

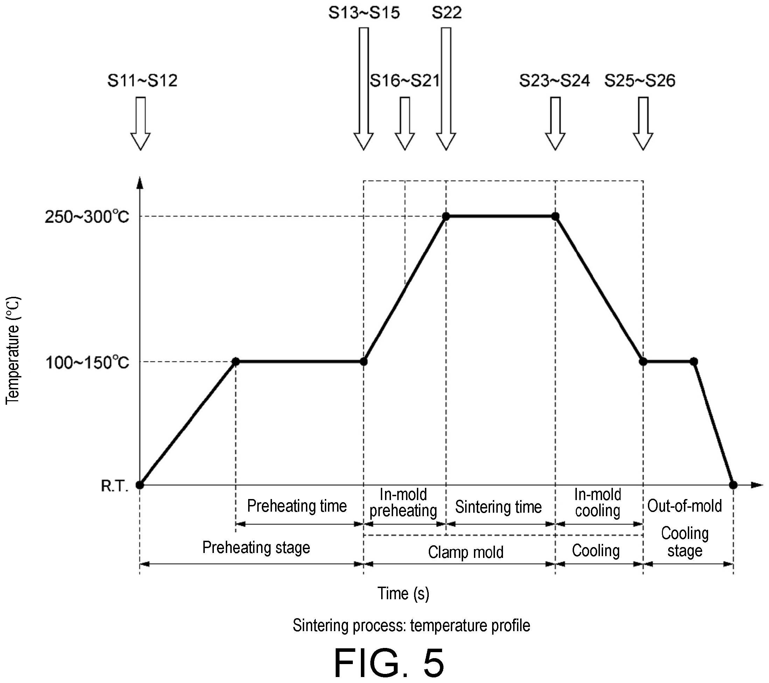

Next, a mounting method using the mounting device 1 according to the present embodiment will be described with reference to FIG. 3 to FIG. 9. FIG. 3 and FIG. 4 are flow diagrams showing an example of the mounting method using the mounting device 1 according to one embodiment of the present invention for mounting multiple electronic components CH11, CH12, CH21, and CH22 on at least one substrate SB1, SB2. FIG. 5 is a graph showing the temperature profile of the mounting method according to one embodiment of the present invention. In the graph of FIG. 4, the horizontal axis indicates time and the vertical axis indicates the temperature of the workpieces W1 and W2.

The mounting method shown in FIG. 3 and FIG. 4 includes: preparing the lower mold 10 and the upper mold 20, closing the lower mold 10 and the upper mold 20, pressing the movable plates 11C and 11D against the biasing force of the coil spring 17B serving as the biasing member with the set pin 16 serving as the pressing member, and retracting the lifter pins 12A and 12B serving as the holding member into the cavity plate 11A to change a distance d (shown in FIG. 1) between the substrates SB1 and SB2 and the heating plate 11A.

First, the lower mold 10 and the upper mold 20 are prepared (S11), and preheating of the lower mold 10 and the upper mold 20 is started (S12). As shown in FIG. 4, the temperature of the workpieces W1 and W2 at this time is room temperature (R.T.). Next, the workpieces W1 and W2 are placed on the lifter pins 12A and 12B (S13). Next, the degassing chambers 31 and 32 are closed and degassing is started (S14), and supply of nitrogen gas is started (S15). By degassing and creating a nitrogen gas atmosphere before raising the temperature of the bonding materials SN11, SN12, SN21, and SN22 to the sintering processing temperature, oxidation of the bonding materials SN11, SN12, SN21, and SN22 is suppressed.

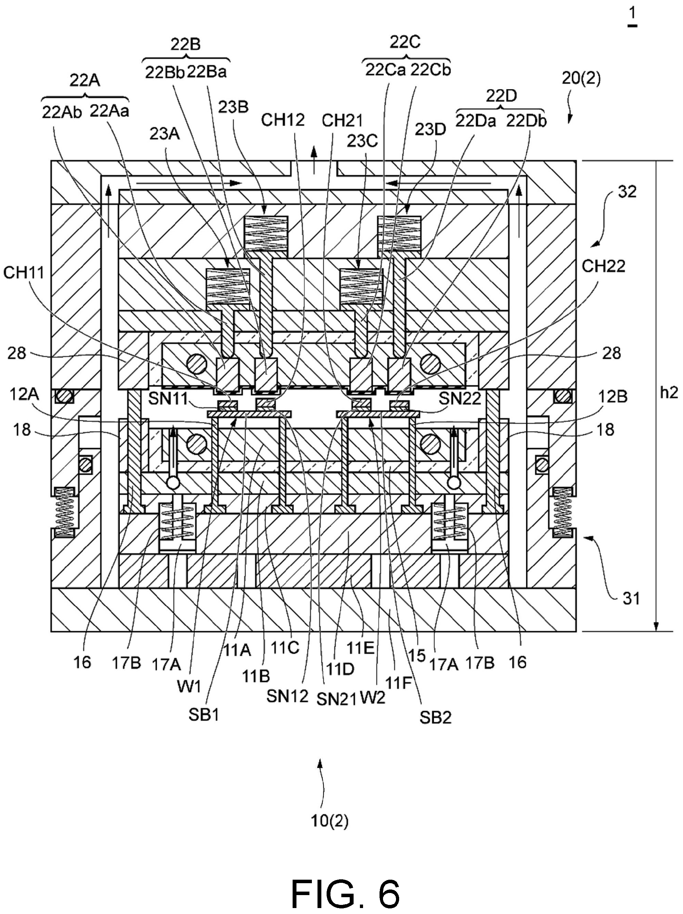

FIG. 6 is a cross-sectional view showing a state in which the mold 2 is closed to the second position h2, the degassing chambers 31 and 32 are closed, and inert gas is supplied while degassing. As shown in FIG. 6, in the case of the mold 2 being closed from the first position h1 shown in FIG. 1 to the second position h2 shown in FIG. 6 and the degassing chambers 31 and 32 being sealed, the tip portion of the set pin 16 comes into contact with the side block 28 of the upper mold 20. However, according to the mold closing at the second position h2, the pressing force of the side block 28 of the upper mold 20 does not press down the movable plates 11C and 11D via the set pin 16.

Therefore, the lifter pins 12A and 12B fixed to the movable plates **11C** and **11D** protrude upward from the cavity plate 11A. The distance d (shown in FIG. 1) is maintained between the substrates SB1 and SB2 and the cavity plate 11A of the lower mold 10. The electronic components CH11, CH12, CH21, and CH22 are gradually heated by thermal radiation. At this time, the temperature of the workpieces W1 and W2 is approximately 100°C to 150°C, as shown in FIG. 5.

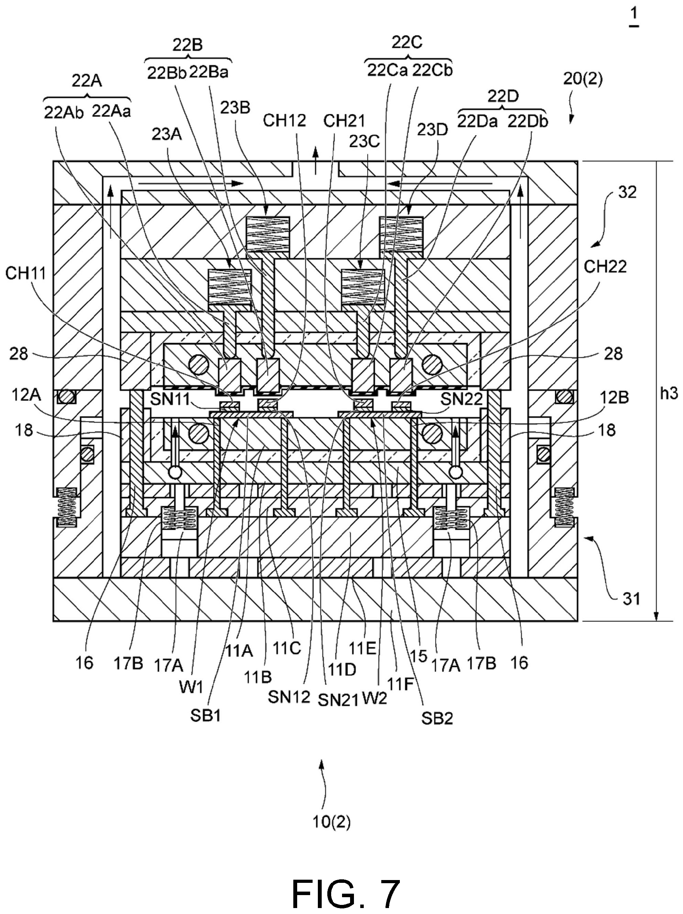

Next, the mold 2 is further closed to the third position h3, and the lifter pins 12A and 12B are cured by the pressing force applied from the upper mold 20 to the set pin 16 (S16). FIG. 7 is a cross-sectional view showing a state in which the mold 2 is closed to the third position H3 and the distance d (shown in FIG. 1) between the substrates SB1 and SB2 and the cavity plate 11A is reduced. As shown in FIG. 7, in response to the lower mold 10 and the upper mold 20 approaching each other, the tip portion of the set pin 16 comes into contact with the side block 28 of the upper mold 20, and the set pin 16 is pressed down.

The pressed set pin 16 presses down the ejector pin plate 11C and the retainer plate 11D connected to the base portion of the set pin 16, and presses down the lifter pins 12A and 12B whose base portions are connected to the ejector pin plate 11C and the retainer plate 11D. As a result, the workpieces W1 and W2 come into contact with the cavity plate 11A.

The substrates SB1 and SB2 are heated by heat conduction from the cavity plate 11A of the lower mold 10, and the electronic components CH11, CH12, CH21, and CH22 are not in contact with the movable pieces 22Ab, 22Bb, 22Cb, and 22Db of the upper mold 20, but are heated by thermal radiation. As shown in FIG. 4, at this time, the temperature of the workpieces W1 and W2 is raised from the preheating temperature of 100°C to 150°C to the sintering processing temperature of 250°C to 300°C.

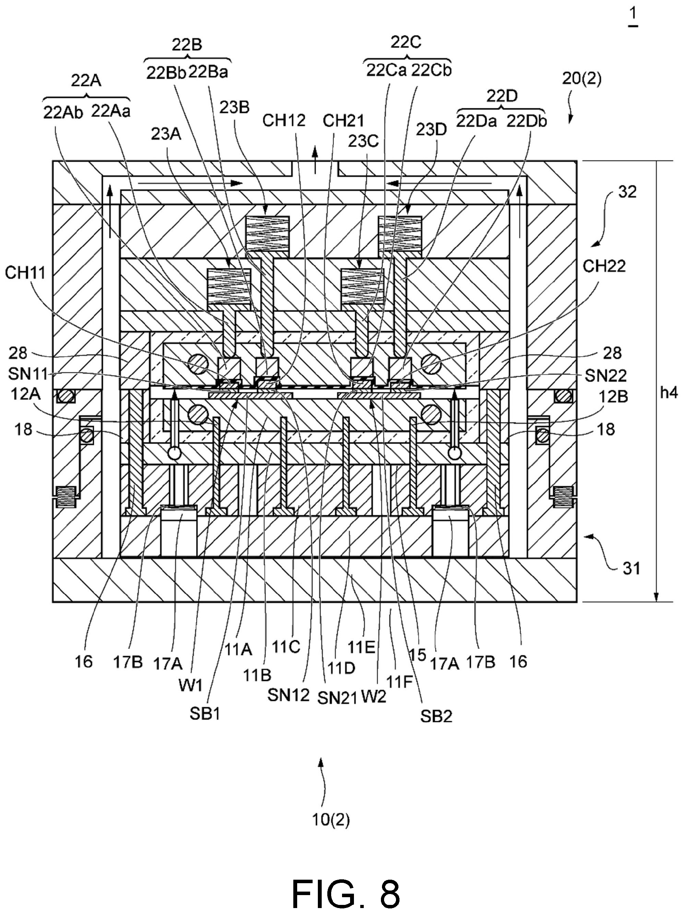

Next, the mold 2 is closed to the fourth position h4, and the movable mechanisms 22A, 22B, 22C, and 22D are brought into contact with the electronic components CH11, CH12, CH21, and CH22 (S21). FIG. 8 shows a state in which the mold is closed to the fourth position h4 and heating is performed by the cavity plate 11A while pressure is applied by the movable piece. As shown in FIG. 8, the side blocks 18 and 28 of the lower mold 10 and the upper mold 20 come into contact with each other, and according to the completion of mold closing, the set pin 16 is pressed down to the maximum.

The movable piece 22Ab of the movable mechanism 22A comes into contact with the electronic component CH11 via the film, and the rod 22Aa of the movable mechanism 22A is pushed up. Similarly, the movable pieces 22Bb, 22Cb, and 22Db of the movable mechanisms 22B, 22C, and 22D respectively come into contact with the electronic components CH12, CH21, and CH22 via the film, and the rods 22Ba, 22Ca, and 22Da of the movable mechanisms 22B, 22C, and 22D are pushed up.

The dimensional differences of the substrates SB1 and SB2, the bonding materials SN11, SN12, SN21, and SN22, and the electronic components CH11, CH12, CH21, and CH22 are absorbed by the penetration depth of the rods 22Aa, 22Ba, 22Ca, and 22Da into the internal space 23. At this time, the temperature of the workpieces W1 and W2 is raised from the preheating temperature of 100°C to 150°C to the sintering processing temperature of 250°C to 300°C, as shown in FIG. 5.

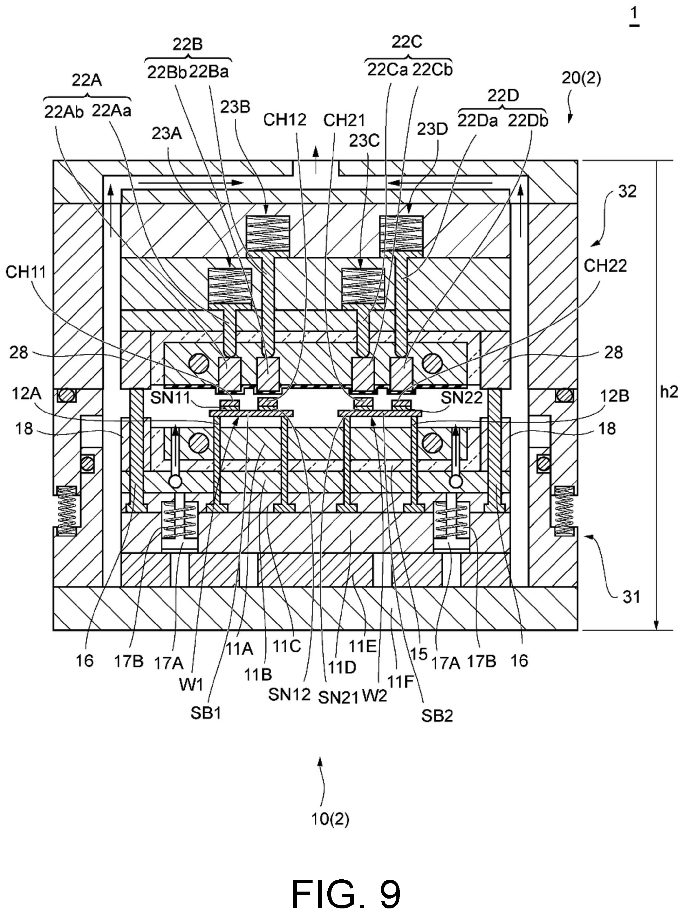

Next, the mold is opened to the second position h2 to remove the pressing force that has been applied to the set pin 16 from the upper mold 20. FIG. 9 is a cross-sectional view showing a state in which the mold is opened to the second position h2 and the distance d between the substrates SB1 and SB2 and the cavity plate 11A is increased. As shown in FIG. 9, in response to the pressing force applied to the set pin 16 being removed, the movable plates 11C and 11D are raised by the biasing force of the spring 17B, and the lifter pins 12A and 12B fixed to the movable plates 11C and 11D are raised (S22).

Next, the supply of inert gas such as nitrogen gas is stopped, and degassing is stopped (S23). Then, as shown in FIG. 1, the mold 2, 3 are opened to the first position H1 to raise the lifter pins 12A and 12B, and the substrates SB1 and SB2 are taken out of the mold 2 (S24).

According to the mounting device 1 of the present embodiment configured as described above and the mounting method using this mounting device 1, it is possible to drive the lifter pins 12A and 12B that change the distance d between the substrates SB1 and SB2 and the cavity plate 11A heated by the heater 14 by the pressing force applied from the upper mold 20 to the set pin 16.

Therefore, in the case where the substrates SB1 and SB2 are not desired to be heated, the substrates SB1 and SB2 are separated from the cavity plate 11A so as not to heat the bonding materials SN11, SN12, SN21, and SN22 for sintering bonding and the solder bumps for solder bonding in a non-pressurized state, making it possible to prevent deterioration of bonding strength. Furthermore, in response to the electronic components CH11, CH12, CH21, and CH22 being mounted, the substrates SB1 and SB2 are promptly separated from the cavity plate 11A to be cooled efficiently.

Since slide motion such as multi-stage motion input from a servo motor or the like to the lower mold 10 or the upper mold 20 can be converted into movement of the lifter pins 12A and 12B serving as the holding member by the set pin 16 serving as the pressing member, there is no need to dispose an additional servo motor for moving the lifter pins 12A and 12B within the lower mold 10 or the upper mold 20. A compactly integrated mounting device 1 can be configured.

Sintering bonding for sintering the bonding materials SN11, SN12, SN21, and SN22 reaches a higher temperature than bump bonding for melting solder bumps or the like. Spring steel, which is a material for coil springs or the like, tends to deteriorate at high temperature. In the mounting device 1 of the present embodiment, the upper mold 20 does not directly press the lifter pins 12A and 12B that hold the workpieces W1 and W2 to retract the lifter pins 12A and 12B, but instead presses the set pin 16 to indirectly retract the lifter pins 12A and 12B, so the spring 17B, etc. serving as the biasing member is less likely to reach high temperature.

The embodiments described above are provided to facilitate understanding of the present invention, and not to limit interpretation of the present invention. Each element included in the embodiments and the arrangement, material, conditions, shape, and size thereof are not limited to those illustrated and may be changed as appropriate. Additionally, configurations shown in different embodiments may be partially substituted or combined with each other.

For example, the pressing member may be configured as a plunger that compresses fluid such as hydraulic oil in response to being pressed by the upper mold 20, and the pressing member and the lifter pins 12A and 12B may be connected by a fluid flow path. In that case, in response to the fluid being compressed by the pressing force applied from the upper mold 20 to the pressing member, the lifter pins 12A and 12B serving as the holding member protrude from the cavity plate 11A.

In the above modification example, the movable plates 11C and 11D may be disposed to serve as counterweights for the pressing member, and the pressing member may be configured to return to the initial position due to the weights of the movable plates 11C and 11D in response to the pressing force from the upper mold 20 being removed. In response to the pressing member returning to the initial position, the lifter pins 12A and 12B retract into the cavity plate 11A.

### [Supplementary Note 1]

The mounting device 1 is a mounting device for mounting at least one electronic component CH11, CH12, CH21, CH22 on at least one substrate SB1, SB2, and includes: the first mold 10 configured to hold the at least one substrate SB1, SB2 on which the at least one electronic component CH11, CH12, CH21, CH22 is placed; and the second mold 20 disposed opposite to the first mold 10. The first mold 10 includes: the heating plate 11A facing the space between the first mold 10 and the second mold 20; the heater 14 heating the heating plate 11A; at least one holding member 12A, 12B holding the at least one substrate SB1, SB2; and at least one pressing member 16 pressed by the second mold 20. The at least one holding member 12A, 12B is configured to be capable of changing the distance d between the at least one substrate SB1, SB2 and the heating plate 11A by the pressing force applied from the second mold 20 to the at least one pressing member 16.

### [Supplementary Note 10]

The mounting method is a mounting method for mounting at least one electronic component CH11, CH12, CH21, CH22 on at least one substrate SB1, SB2, and includes: preparing the first mold 10 configured to hold the at least one substrate SB1, SB2 on which the at least one electronic component CH11, CH12, CH21, CH22 is placed; and preparing the second mold 20 disposed opposite to the first mold 10. The first mold 10 includes: the heating plate 11A facing the space between the first mold 10 and the second mold 20; the heater 14 heating the heating plate 11A; at least one holding member 12A, 12B holding the at least one substrate SB1, SB2; and at least one pressing member 16 pressed by the second mold 20. The mounting method further includes: changing, by the at least one holding member 12A, 12B, the distance d between the at least one substrate SB1, SB2 on which the at least one electronic component CH11, CH12, CH21, CH22 is placed or mounted and the heating plate 11A by the pressing force applied from the second mold 20 to the at least one pressing member 16.

According to the supplementary notes 1 and 10 described above, the holding members 12A and 12B that change the distance d between the substrates SB1 and SB2 and the heating plate 11A heated by the heater 14 are moved by the pressing force applied from the second mold 20 to the pressing member 16, and the substrates SB1 and SB2 can be separated from the heating plate 11A, which is a heat source, in the case where the substrates SB1 and SB2 are not desired to be heated. Therefore, for example, it is possible to prevent the bonding materials SN11, SN12, SN21, and SN22 for sintering bonding or the solder bumps for solder bonding from being heated in a non-pressurized state, making it possible to prevent deterioration of bonding strength. For example, in response to the electronic components CH11, CH12, CH21, and CH22 being mounted, the substrates SB1 and SB2 can be promptly separated from the heating plate 11A to be cooled efficiently. Since there is no need to add a motor or the like for moving the holding members 12A and 12B inside the mold 2, a compact mounting device 1 can be provided.

### [Supplementary Note 2]

In the supplementary note 1 described above, the first mold 10 may further include: the movable plates 11C and 11D facing the heating plate 11A from the side opposite to the second mold 20; and at least one biasing member 12 biasing the movable plates 11C and 11D toward the heating plate 11A. The at least one holding member 12A, 12B may be fixed to the movable plates 11C and 11D in a state of being inserted into the through hole penetrating the heating plate 11A. In response to the movable plates 11C and 11D approaching the heating plate 11A due to the biasing force of the at least one biasing member 17B, the at least one holding member 12A, 12B may protrude from the heating plate 11A and the distance d between the at least one substrate SB1, SB2 supported by the at least one holding member 12A, 12B and the heating plate 11A may increase, and in response to the pressing member 16 pressing the movable plates 11C and 11D against the biasing force of the at least one biasing member 12, the at least one holding member 12A, 12B may retract into the heating plate 11A and the distance d between the at least one substrate SB1, SB2 supported by the at least one holding member 12A, 12B and the heating plate 11A may decrease.

According to the supplementary note 2 described above, the mounting device 1 that changes the distance d between the substrates SB1 and SB2 and the heating plate 11A by the pressing force from the second mold 20 can be configured compactly.

### [Supplementary Note 3]

In the supplementary note 2 described above, a thermal insulation member 15 may be disposed between the heater 14 and the heating plate 11A and the biasing member 17B.

According to the supplementary note 3 described above, the temperature of the biasing member 17B can be suppressed from rising, making it possible to use spring steel that easily deteriorates at high temperatures as the material for the biasing member 17B.

### [Supplementary Note 4]

In any one of the supplementary notes 1 to 3 described above, the at least one holding member 12A, 12B may be multiple holding members 12A and 12B, each of the multiple holding members 12A and 12B may be formed in a rod shape, and the at least one substrate SB1, SB2 may be supported by the tip portions of the multiple holding members 12A and 12B.

According to the supplementary note 4 described above, since the contact area between the holding members 12A and 12B such as lifter pins and the substrates SB1 and SB2 is small, heat transfer from the holding members 12A and 12B is small. The substrates SB1 and SB2 can be cooled rapidly.

### [Supplementary Note 5]

In any one of the supplementary notes 1 to 4 described above, at least one of the first mold 10 and the second mold 20 may further include the gas supply port 13 that supplies gas toward the at least one substrate SB1, SB2 and the at least one electronic component CH11, CH12, CH21, CH22.

According to the supplementary note 5 described above, gas can be supplied from the gas supply port 13 to rapidly cool the substrates SB1 and SB2.

### [Supplementary Note 6]

In the supplementary note 5 described above, the gas supply port 13 may supply gas to flow along the upper surface and the lower surface of the at least one substrate SB1, SB2.

According to the supplementary note 6 described above, the upper surfaces and the lower surfaces of the substrates SB1 and SB2 can be cooled simultaneously to rapidly cool the substrates SB1 and SB2.

### [Supplementary Note 7]

In the supplementary note 5 or 6 described above, the gas supplied from the gas supply port 13 may be inert gas.

According to the supplementary note 7 described above, since inert gas is blown, oxidation of the substrates SB1 and SB2, etc. can be suppressed compared to the case of blowing air containing oxygen. Moreover, in the case of further including the degassing chambers 31 and 32, the gas supply port 13 for supplying gas to cool the substrates SB1 and SB2 and the gas supply port for filling the atmosphere furnace with inert gas can be shared, making it possible to suppress an increase in the number of parts and configure a compact mounting device 1.

### [Supplementary Note 8]

In any one of the supplementary notes 1 to 7 described above, the mounting device may further include the degassing chambers 31 and 32 that are openable and closable and surround the lower mold 10 and the second mold 20, and may be configured to reduce oxygen concentration in the space inside the mold by degassing with the degassing chambers 31 and 32 and supplying inert gas.

In the case of heating the substrates SB1 and SB2 and the electronic components CH11, CH12, CH21, and CH22 to high temperatures for sintering bonding or the like, the substrates SB1 and SB2 and the electronic components CH11, CH12, CH21, and CH22 are oxidized under the air atmosphere. According to the supplementary note 8 described above, the electronic components CH11, CH12, CH21, and CH22 can be mounted on the substrates SB1 and SB2 under an inert gas atmosphere with reduced oxygen concentration.

### [Supplementary Note 9]

In any one of the supplementary notes 1 to 8 described above, the mounting device 1 may be a sintering device that sinters the bonding material 103 disposed between the at least one substrate SB1, SB2 and the at least one electronic component CH11, CH12, CH21, CH22 by heating and pressurizing the bonding material 103 to bond the at least one substrate SB1, SB2 and the at least one electronic component CH11, CH12, CH21, CH22.

According to the supplementary note 9 described above, in the case where the bonding materials SN11, SN12, SN21, and SN22 for sintering bonding are heated without being pressurized, the bonding materials SN11, SN12, SN21, and SN22 become brittle and stick together. However, since the substrates SN1 and SN2 can be separated from the heating plate 11A, which is a heat source, in the case where the substrates SN1 and SN2 are not desired to be heated, a decrease in adhesive strength can be prevented. Therefore, it is suitable for a sintering device.

### Description of Reference Numerals

1...mounting device, 2...mold, 3...press device, 4...lower platen, 5...upper platen, 9...pressure adjustment mechanism, 10...lower mold (example of first mold), 11A...cavity plate (example of heating plate), 11B...lower mold chase, 11C...ejector pin plate (example of movable plate), 11D...retainer plate (example of movable plate), 11E...support pillar, 11F...lower mold base, 12A, 12B...lifter pin (example of holding member), 13...gas supply port, 14...heater, 15...thermal insulation member, 16...set pin (example of pressing member), 17A...spring sleeve, 17B...spring, 18...side block, 20...upper mold (example of second mold), 21A...cavity plate, 21B...upper mold chase, 21C...lower support plate, 21D...upper support plate, 21E...upper mold base, 22A, 22B, 22C, 22D...movable mechanism, 22Aa, 22Ba, 22Ca, 22Da...rod, 22Ab, 22Bb, 22Cb, 22Db...movable piece, 23...internal space, 24...heater, 25...thermal insulation member, 27...degassing path, 28...side block, 29...degassing port, 31, 32...degassing chamber, 33, 34...degassing path, CH11, CH12, CH21, CH22...electronic component, d...distance between substrate and heating plate, h1, h2, h3, h4...first to fourth positions, SB1, SB2...substrate, SN11, SN12, SN21, SN22...bonding material, W1, W2...workpiece.

## Claims

1. A mounting device for mounting at least one electronic component on at least one substrate, the mounting device comprising:
a first mold configured to hold the at least one substrate on which the at least one electronic component is placed; and
a second mold disposed opposite to the first mold,
wherein the first mold comprises:
a heating plate facing a space between the first mold and the second mold;
a heater heating the heating plate;
at least one holding member holding the at least one substrate; and
at least one pressing member pressed by the second mold,
wherein the at least one holding member is configured to be capable of changing a distance between the at least one substrate and the heating plate by a pressing force applied from the second mold to the at least one pressing member.

2. The mounting device according to claim 1, wherein the first mold further comprises:
a movable plate facing the heating plate from a side opposite to the second mold; and
at least one biasing member biasing the movable plate toward the heating plate,
wherein the at least one holding member is fixed to the movable plate in a state of being inserted into a through hole penetrating the heating plate,
in response to the movable plate approaching the heating plate due to a biasing force of the at least one biasing member, the at least one holding member protrudes from the heating plate and a distance between the at least one substrate supported by the at least one holding member and the heating plate increases, and
in response to the pressing member pressing the movable plate against the biasing force of the at least one biasing member, the at least one holding member retracts into the heating plate and the distance between the at least one substrate supported by the at least one holding member and the heating plate decreases.

3. The mounting device according to claim 2, wherein a thermal insulation member is disposed between the heater and the heating plate and the biasing member.

4. The mounting device according to claim 1, wherein the at least one holding member is a plurality of holding members,
each of the plurality of holding members is formed in a rod shape, and
the at least one substrate is supported by tip portions of the plurality of holding members.

5. The mounting device according to claim 1, wherein at least one of the first mold and the second mold further comprises at least one gas supply port that supplies gas toward the at least one substrate and the at least one electronic component.

6. The mounting device according to claim 5, wherein the at least one gas supply port supplies gas to flow along an upper surface and a lower surface of the at least one substrate.

7. The mounting device according to claim 5, wherein the gas supplied from the at least one gas supply port is inert gas.

8. The mounting device according to claim 1, further comprising a degassing chamber that is openable and closable and surrounds the first mold and the second mold, wherein the mounting device is configured to reduce oxygen concentration in the space by reducing pressure inside the degassing chamber and supplying inert gas.

9. The mounting device according to claim 1, wherein the mounting device is a sintering device that sinters a bonding material disposed between the at least one substrate and the at least one electronic component by heating and pressurizing the bonding material to bond the at least one substrate and the at least one electronic component.

10. A mounting method for mounting at least one electronic component on at least one substrate, the mounting method comprising:
preparing a first mold configured to hold the at least one substrate on which the at least one electronic component is placed; and
preparing a second mold disposed opposite to the first mold,
wherein the first mold comprises:
a heating plate facing a space between the first mold and the second mold;
a heater heating the heating plate;
at least one holding member holding the at least one substrate; and
at least one pressing member pressed by the second mold,
wherein the mounting method further comprises changing, by the at least one holding member, a distance between the at least one substrate on which the at least one electronic component is placed or mounted and the heating plate by a pressing force applied from the second mold to the at least one pressing member.
